# EUROPEAN PATENT APPLICATION

(11) **EP 4 379 817 A1**
(43) Date of publication of application: **05.06.2024**
(21) Application number: 22849137.9
(22) Date of filing: 29.06.2022
(51) Int. Cl.: H01L 31/05, H01L 31/048, H02S 10/40, H02S 40/36

(54) **SOLAR CELL MODULE AND SOLAR POWER GENERATION SYSTEM**

(30) Priority: 26.07.2021 JP 2021121832
(71) Applicant: Sharp Kabushiki Kaisha, Sakai-shi Osaka 590-8522 (JP)
(72) Inventor: OKAMOTO, Chikao, Sakai City, Osaka 590-8522 (JP); NAKAMURA, Kyotaro, Nagoya-Shi, Aichi 468-8511 (JP)
(74) Representative: Müller Hoffmann & Partner
(86) International application number: PCT/JP2022/026073
(87) International publication number: WO 2023/008068

(57) **Abstract**

A solar cell module (1) includes: a plurality of solar cells (10) spaced apart from each other and arranged in a first direction (D1) and a second direction (D2); and connection members (31, 32) electrically connecting the plurality of solar cells. The solar cells are arranged along a curved-face shape. Those solar cells that are adjacent to each other in the first direction are electrically connected in series with each other. Those solar cells that are adjacent to each other in the second direction are electrically connected in parallel with each other.

## Description

### Technical Field

The present disclosure relates to solar cell modules and solar power generation systems, both including a plurality of solar cells.

### Background Art

Development has been underway in vehicles such as automobiles for installation of a solar power generation system in which a solar cell module is disposed on the surface of the vehicle body to convert light energy to electrical energy. The electric power generated by the solar cell module is voltage-converted by a power converter such as a DC/DC converter for charging a battery.

For instance, Patent Literature 1 discloses a solar cell module including a plurality of solar cells and disposed on a roof of a vehicle, wherein there are provided a sealing film and a top film so as to cover the entire solar cells over the backseat. The backseat is formed from a thermoplastic resin sheet by vacuum molding or heat press molding so as to have a curved-face shape along the roof.

### Citation List

### Patent Literature

Patent Literature 1: Japanese Unexamined Patent Application Publication No. 2012-33573

### Summary of Invention

### Technical Problem

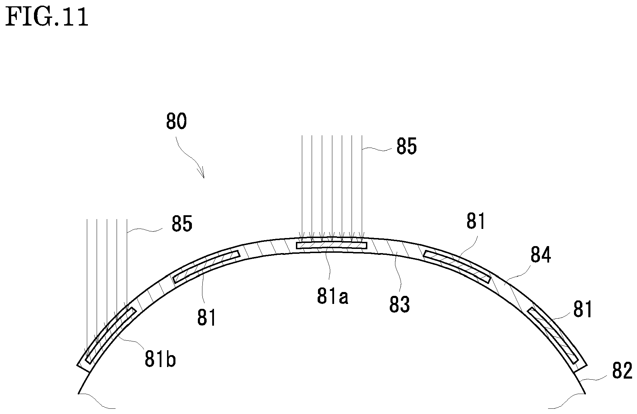

In this type of solar power generation system, the solar cell module can ideally receive sunlight uniformly across the entire surface thereof. However, the installation surfaces of vehicles for the solar cell module do not make a plane, but are curved with various curvatures. Referring to FIG. 11, for example, to dispose a solar cell module 80 including a plurality of solar cells 81 on an installation surface 82 that has a curved shape, the solar cells 81 would have different installation configurations, for example, a solar cell 81a that is disposed in a more or less horizontal position and a solar cell 81b that is disposed at an angle, depending on where the solar cells 81 is disposed. The same description applies to those solar cell modules that are disposed on a curved portion of buildings and like structures.

The solar cell module 80, when disposed on a curved face, could fail to achieve a suitable angle of inclination relative to sunlight 85, depending on the position of the solar cells 81 even if the sunlight 85 equally strikes the solar cells 81. Therefore, the quantity of incoming solar radiation for the solar cells 81 may differ from one solar cell to the other, which will lead to the solar cells 81 (e.g., solar cells 81a, 81b) producing difference electric current values.

When a difference occurs among the electric current values generated by the solar cells in the solar cell module, for example, one of the series-connected solar cells may generate a smaller current than the others, and the electric current value available from the entire solar cell module is capped by the small electric current value of that particular solar cell, which undesirably reduces electric power generation.

Another problem is the shadow that can be cast on the solar cell module by elevated roads and train tracks, buildings, and other like structures that can block sunlight as the vehicle travels in varying environments. Under these circumstances, there are chances of the solar cells producing different electric current values and consequently of the electric current value available from the entire solar cell module being capped undesirably by the reduced electric current value under the shadow.

The present disclosure has been made in view of these conventional issues and has an object to provide a solar cell module that is both capable of stable electric power generation and suited to an installation on a curved face and also to provide a solar power generation system including such a solar cell module.

### Solution to Problem

A means to solve the issues in accordance with the present disclosure for achieving the object is based on a solar cell module including: a plurality of solar cells spaced apart from each other and arranged in a first direction and a second direction perpendicular to the first direction; and a connection member electrically connecting the plurality of solar cells, wherein the plurality of solar cells are flat, sealed by a resin layer having a curved-face shape, and arranged along the curved-face shape, and the solar cell module includes a solar cell group in which the connection member electrically connects those solar cells in the plurality of solar cells that are adjacent to each other in the first direction in series with each other and electrically connects those solar cells in the plurality of solar cells that are adjacent to each other in the second direction in parallel with each other.

More concrete configurations of the solar cell module include the following. In the solar cell module configured as above, the solar cell module may include a plurality of the solar cell groups arranged in the second direction, and those adjacent solar cell groups in the plurality of solar cell groups may be electrically connected in parallel with each other.

In addition, in the solar cell module configured as above, those solar cells in the plurality of solar cells that are arranged in the first direction in one of adjacent solar cell groups in the plurality of solar cell groups may be equal in number to those solar cells in the plurality of solar cells that are arranged in the first direction in another one of the adjacent solar cell groups.

In addition, in the solar cell module configured as above, those solar cells in the plurality of solar cells that are in one of adjacent solar cell groups in the plurality of solar cell groups may be equal in total number to those solar cells in the plurality of solar cells that are in another one of the adjacent solar cell groups.

In addition, in the solar cell module configured as above, those solar cells in the plurality of solar cells that are in one of adjacent solar cell groups in the plurality of solar cell groups may be greater in total number than those solar cells in the plurality of solar cells that are in another one of the adjacent solar cell groups.

To achieve the object, the technical concept of the present disclosure encompasses solar power generation systems including the solar cell module that is in accordance with each means to solve the issues described above. As such a solar power generation system, the solar cell module is installed on an installation surface having a curved-face shape.

In addition, in the solar power generation system, preferably, an arrangement unit is specified in which the plurality of solar cells are disposed in accordance with the curved-face shape of the installation surface, and one of the plurality of solar cell groups is provided in each arrangement unit, and the plurality of solar cell groups in the solar cell module are electrically connected in parallel with each other.

In addition, in the solar power generation system configured as above, the installation surface may be either a surface of a vehicle or a surface of a structure fixed to ground.

By providing the solar cell module having the foregoing invention-identifying features and the solar power generation system including the solar cell module, it is possible to provide both a connecting structure in which the solar cells are connected in series with each other and a connecting structure in which the solar cells are connected in parallel with each other, to allow an electric current to flow skirting around those in the plurality of solar cells that are producing a low electric current value, and to solves the problem that current flow is capped to the low electric current value. That in turn enables stabilizing the electric power generation of the solar cell module.

### Advantageous Effects of Invention

The solar cell module and the solar power generation system in accordance with the present disclosure enable restricting decreases in the available electric current value and hence achieving stable electric power generation even when installed on a curved face.

### Brief Description of Drawings

FIG. 1 is a schematic plan view of a structure of a solar cell module in accordance with Embodiment 1 of the present disclosure.
FIG. 2 is a cross-sectional view of an internal structure of the solar cell module.
FIG. 3 is a plan view of a vehicle including the solar cell module, the vehicle being a solar power generation system in accordance with Embodiment 1 of the present disclosure.
FIG. 4 is a front view of the vehicle shown in FIG. 3.
FIG. 5A is a cross-sectional view, taken along line A-A in FIG. 1, of the solar cell module installed on the foregoing vehicle.
FIG. 5B is a cross-sectional view, taken along line B-B in FIG. 1, of the solar cell module installed on the foregoing vehicle.
FIG. 6 is a schematic plan view of a structure of a solar cell module in accordance with Embodiment 2 of the present disclosure.
FIG. 7 is a schematic plan view of a structure of a solar cell module in accordance with Embodiment 3 of the present disclosure.
FIG. 8 is a schematic plan view of a structure of a solar cell module in accordance with Embodiment 4 of the present disclosure.
FIG. 9 is a cross-sectional view, taken along line C-C in FIG. 8, of the solar cell module installed on the foregoing vehicle.
FIG. 10 is a perspective view of a plastic greenhouse including one of the foregoing solar cell modules.
FIG. 11 is a diagram illustrating the quantity of incoming solar radiation on a conventional solar cell module disposed on a curved installation surface.

### Description of Embodiments

The following will describe a solar cell module and a solar power generation system both in accordance with an embodiment of the present disclosure, with reference to drawings.

### Embodiment 1

### Solar cell module

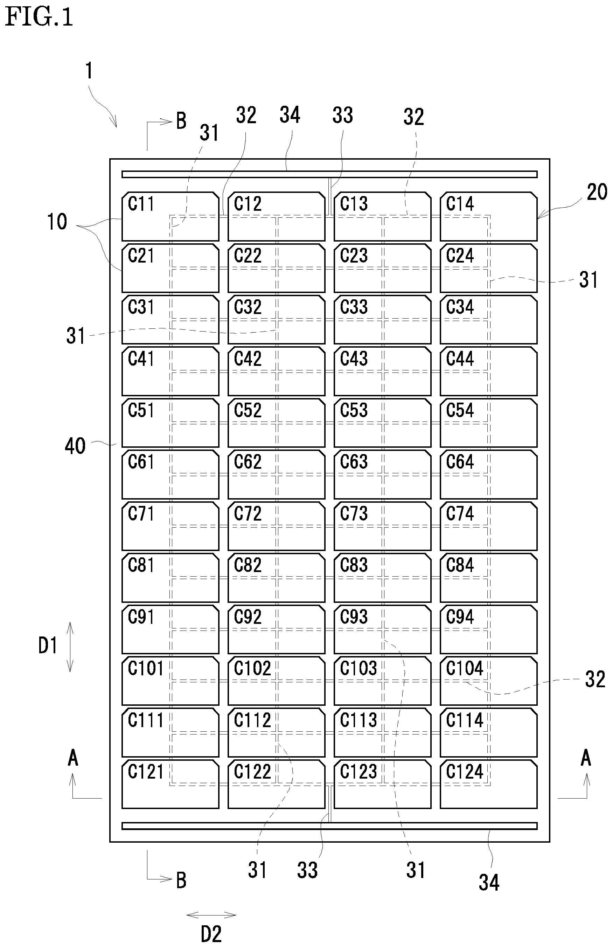

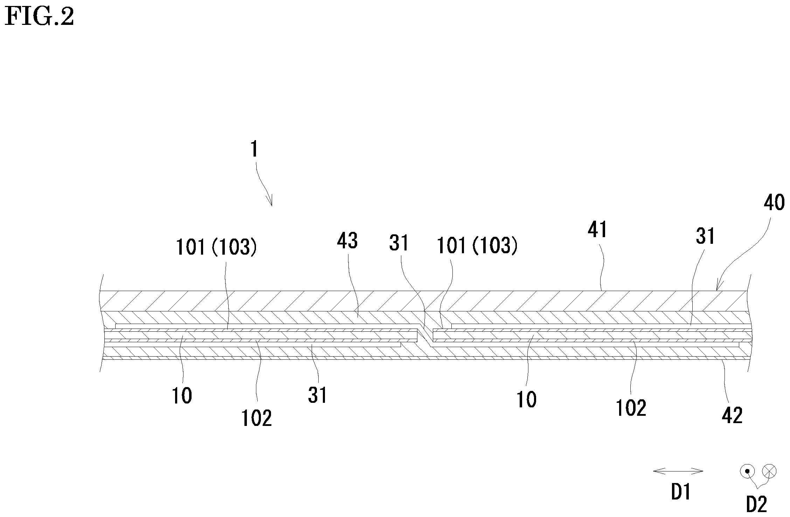

FIG. 1 is a schematic plan view of a structure of a solar cell module 1 in accordance with Embodiment 1 of the present disclosure. FIG. 2 is a cross-sectional view of an internal structure of the solar cell module 1. Note that FIG. 1 omits the resin layer and the protection member, among others, included in the solar cell module 1.

Referring to FIG. 1, the solar cell module 1 includes a panel 40 that in turn includes: a plurality of solar cells 10 spaced apart from each other; and a plurality of connection members (31, 32 ...) that electrically connect the plurality of solar cells 10.

Referring to FIG. 2, the solar cell module 1 has a structure in which the solar cells 10 and other components are sealed by a transparent resin layer 43 between a transparent substrate 41 and a protection member 42. The resin layer 43 is curved in at least a part of the solar cell module 1, so that the transparent substrate 41 and the protection member 42 are disposed along the curved-face shape of the resin layer 43. In addition, as described later, each solar cell 10 is sealed by the resin layer 43 and disposed along the curved-face shape of the resin layer 43.

The solar cell 10 is a flat photovoltaic element for generating electric power under light and includes a front-side electrode 101 and a backside electrode 102. For example, the front-side electrode 101 includes a busbar electrode 103 and a finger electrode (not shown). The busbar electrode 103 is formed like a linear band extending in a first direction D1 on the front side of the solar cell 10. The finger electrode is formed extending in a second direction D2 from both ends of the busbar electrode 103. The finger electrode is provided in such a pattern as to run across the entire light-receiving face of the solar cell 10 at fixed intervals therebetween.

The backside electrode 102 is formed like a linear band extending in the first direction D1 on the backside of the solar cell 10, opposite the busbar electrode 103. The first connection member 31 is connected to the busbar electrode 103 in the front-side electrode 101 of one of the two solar cells 10 and also to the backside electrode 102 of the other one of the two solar cells 10, thereby connecting these two adjacent solar cells 10 in series. The transparent substrate 41 is disposed opposite the front side of the solar cell 10 (on the upper side in FIG. 2). The protection member 42 is disposed opposite the backside of the solar cell 10 (on the lower side in FIG. 2).

The first connection member 31 includes a base material shaped like an elongated strip or a wire with a substantially circular cross-section, the outer surface of the base material or wire being coated with either a conductive adhesive or a solder. The base material or wire may be made of any substance and may be made of, for example, a metal such as copper.

The configuration in FIG. 1 illustrates an example where each solar cell 10 (C11 to C124) in the solar cell module 1 is flat and resides on one of two segments into which a solar cell substrate measuring, for example, approximately 156 mm on each side is divided. The solar cell 10, on one of the two segments into which the solar cell substrate into is divided, has overall dimensions of approximately 156 mm by 78 mm on respective sides and has two corners beveled (cut off) on a side thereof that extends in a prescribed direction (e.g., in the second direction D2) as shown in the Figure.

The solar cells 10, each structured in this manner, are arranged in a matrix in the first direction (column direction) D1 and the second direction (row direction) D2. Referring to FIG. 1, the solar cell module 1 in accordance with the illustrative configuration includes a total of 4×12 = 48 solar cells 10 (C11 to C14, C21 to C24, C31 to C34, C41 to C44, C51 to C54, C61 to C64, C71 to C74, C81 to C84, C91 to C94, C101 to C104, C111 to C114, C121 to C124).

As an example, the solar cells C11, C21, which are disposed adjacent to each other in the first direction D1, are connected in series with each other by the first connection member 31 disposed in the first direction D1. Specifically, the first connection member 31 is positioned parallel to the front face of the solar cell C11 which is flat and joined on the bottom face of the first connection member 31 to the front face of the solar cell C11 and on the top face of the first connection member 31 to the back face of the solar cell C21.

Meanwhile, as an example, the solar cells C11, C12, which are disposed adjacent to each other in the second direction D2, are connected in parallel with each other by the second connection member 32 disposed in the second direction D2. The solar cells C13, C14, which are disposed adjacent to each other in the second direction D2, are similarly connected in parallel with each other by the second connection member 32.

The second connection member 32 includes a base material shaped like an elongated strip or a wire with a substantially circular cross-section, the outer surface of the base material or wire being coated with either a conductive adhesive or a solder. The base material or wire may be made of any substance and may be made of, for example, a metal such as copper. In addition, the second connection member 32 may be made of metal foil such as copper foil. The second connection member 32 is connected to the first connection member 31 or an electrode of the solar cell 10, thereby connecting in parallel the solar cells 10 that are adjacent to each other in the second direction D2. For example, the second connection member 32 is disposed on the backside of the solar cell 10 and connected to the first connection member 31 connected to the backside electrode 102 of one of the two solar cells 10 and is also connected to the first connection member 31 connected to the backside electrode 102 of the other one of the two solar cells 10, thereby connecting in parallel the solar cells 10 that are adjacent to each other in the second direction D2.

The plurality of solar cells 10 in the solar cell module 1 are configured in this manner so that one of every two solar cells 10 that are adjacent to each other in the first direction D1 is electrically connected in series with the other one of the two solar cells 10 and that one of every two solar cells 10 that are adjacent to each other in the second direction D2 is electrically connected in parallel with the other one of the two solar cells 10, thereby forming a solar cell group 20. In other words, the solar cell group 20 in the solar cell module 1 has both a connecting structure in which the solar cells 10 are connected in series with each other and a connecting structure in which the solar cells 10 are connected in parallel with each other. Along the edge of the solar cell group 20, the solar cells 10 are connected to an edge electrode wire 34 via an intermediate connection wire 33 connected to the second connection member 32.

### Solar power generation system

A description is now given of, as a solar power generation system in accordance with Embodiment 1, an example where the solar cell module 1 is installed on a vehicle 60.

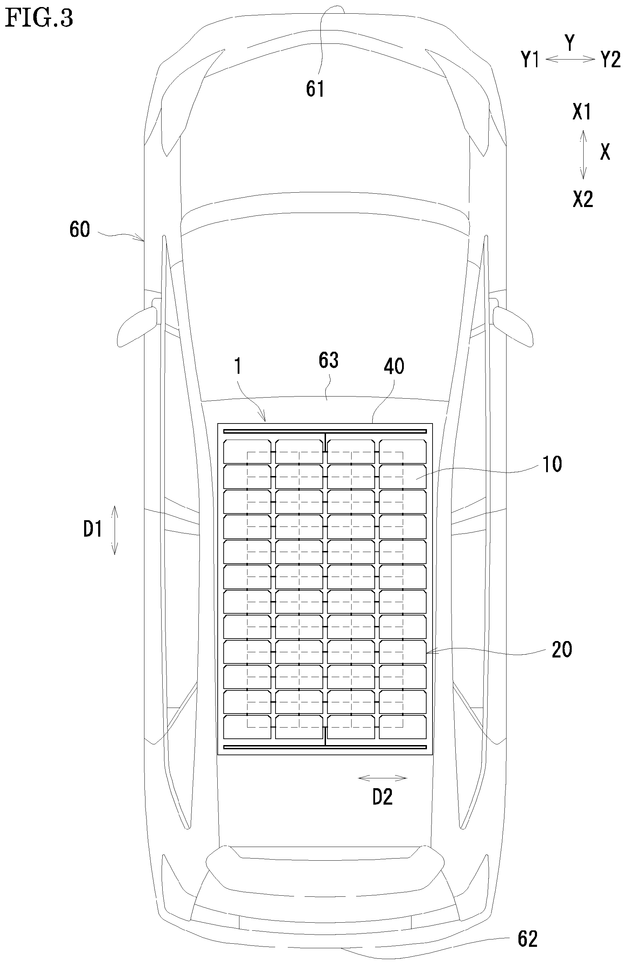

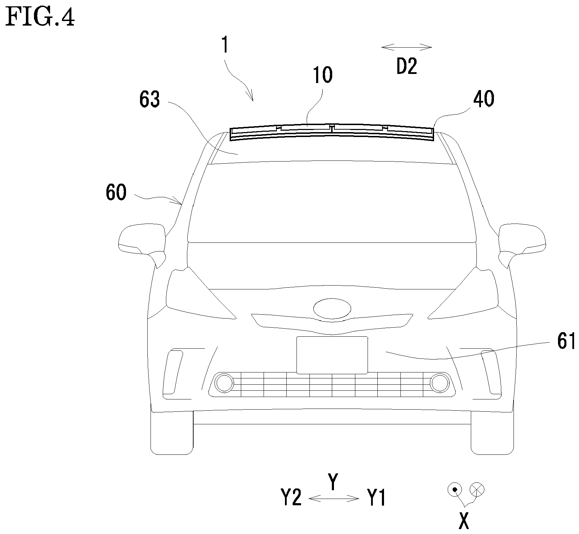

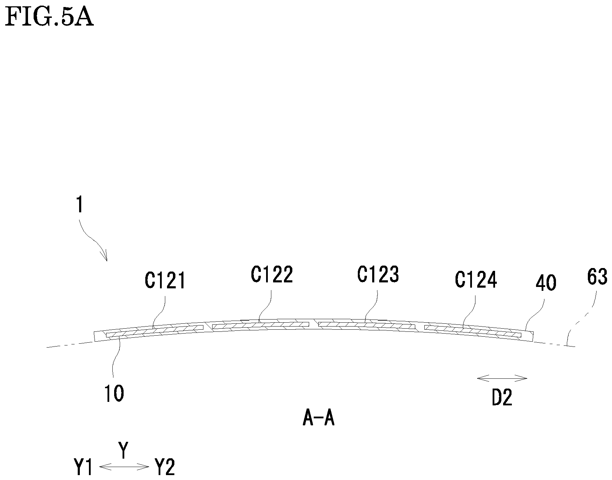

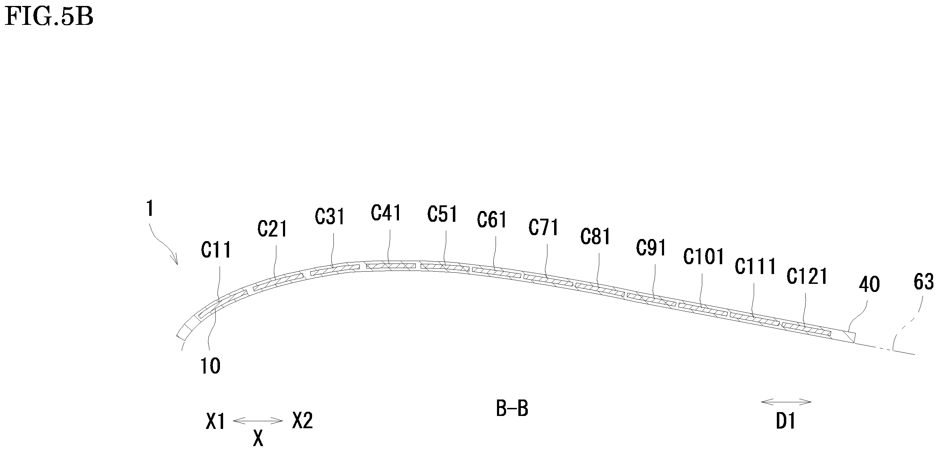

FIG. 3 is a plan view of the vehicle 60 including the solar cell module 1, the vehicle 60 being an example of a solar power generation system in accordance with an embodiment of the present disclosure. FIG. 4 is a front view of the vehicle 60 shown in FIG. 3. In addition, FIGs. 5A and 5B schematically illustrate a cross-section of the solar cell module 1 as installed on the vehicle 60, FIG. 5A being a cross-sectional view taken along line A-A in FIG. 1 and FIG. 5B being a cross-sectional view taken along line B-B in FIG. 1.

The solar cell module 1 may be installed, for example, on a roof 63 of the vehicle 60 such as an automobile. A front-back direction X for the vehicle 60 corresponds to the total length direction of the vehicle 60 as measured from the very front of the vehicle (vehicle front 61) to the very rear of the vehicle (vehicle rear 62) and is parallel to the forward or reverse direction. A width direction Y for the vehicle 60 corresponds to the left and right direction of the vehicle 60 and is perpendicular to the front-back direction X for the vehicle 60. In the illustrative configuration, the roof 63 of the vehicle 60, which provides an installation surface for the solar cell module 1, is formed at least partially with a curved-face shape. The panel 40 (resin layer 43) in the solar cell module 1 is disposed along the surface of the roof 63 and for this reason, overall has a curved-face shape that is similar to the roof 63.

Referring to FIGs. 3 and 4, the solar cell module 1 is so positioned on the roof 63 of the vehicle 60 that the first direction D1 is parallel to the front-back direction X for the vehicle 60 and the second direction D2 is parallel to the width direction Y for the vehicle 60. The plurality of solar cells 10 in the solar cell module 1 are disposed along the curved-face shape of the roof 63 inside the panel 40 in the front-back direction X and the width direction Y

In other words, as shown in FIG. 5A, the plurality of solar cells 10 in the solar cell module 1 are disposed along a gently curved-face shape in the second direction D2 which corresponds to the width direction Y for the vehicle 60. In addition, as shown in FIG. 5B, the plurality of solar cells 10 are disposed along curved-face shapes with different curvatures on one of two edges end on the other edge in the first direction D1 which corresponds to the front-back direction X for the vehicle 60.

Here, as shown in FIG. 5B, the solar cell C11 (C12, C13, C14) that is disposed on the vehicle front 61 side (front side X1) is disposed at greater angles of inclination than, for example, the solar cell C121 (C122, C123, C124) that is disposed on the vehicle rear 62 side (rear side X2). In addition, the solar cells C41, C51 and the like that are disposed in the intermediate part in terms of the first direction D1 are disposed almost substantially horizontal at smaller angles of inclination than the solar cell C11. The light-receiving faces of the solar cells 10 are arranged to face various directions.

As described here, at least one of the plurality of solar cells 10 in the solar cell module 1 (e.g., the solar cell C11 which is positioned on an edge in the example shown in FIG. 5B) is disposed on a curved segment with a large curvature. This solar cell 10 has a smaller power generation area and different electrical properties (especially, electric current) than the other solar cells 10 disposed on curved segments with a smaller curvature.

In the solar cell module with a conventional structure, under such circumstances, the electric current flows in the plurality of types of solar cells with different electrical properties do not match up, and as described above, the electric current value available from the entire solar cell module is capped by the electric current value of the solar cell with the smallest electric current via the series-connected circuitry. As a result, there is a problem that electric power cannot be efficiently extracted (output is reduced). In addition, when shadow is cast by, for example, a building on the solar cell module, those solar cells in the shadow receive a smaller quantity of solar radiation, hence producing a smaller electric current value that caps the electric current value available from the entire solar cell module.

In contrast, the solar cell module 1 in accordance with the present embodiment has both a connecting structure in which the solar cells 10 are connected in series with each other and a connecting structure in which the solar cells 10 are connected in parallel with each other. Those solar cells 10 that are adjacent to each other the second direction D2 are connected in parallel with each other. Since the solar cell 10 with a reduced electric current value acts as electrical resistance, electric current flows through parallel-connected circuitry that skirts around the solar cell 10. Therefore, it becomes possible to solve conventional problem that the electric current value of one of the solar cells 10 is capped and reduced by the low electric current value of the other solar cell 10. Therefore, it becomes possible to restrict decreases in the electric power generation caused by the solar cell module 1, which enables stable electric power generation even in an installation configuration having a curved-face shape like the roof 63 of the vehicle 60.

### Embodiment 2

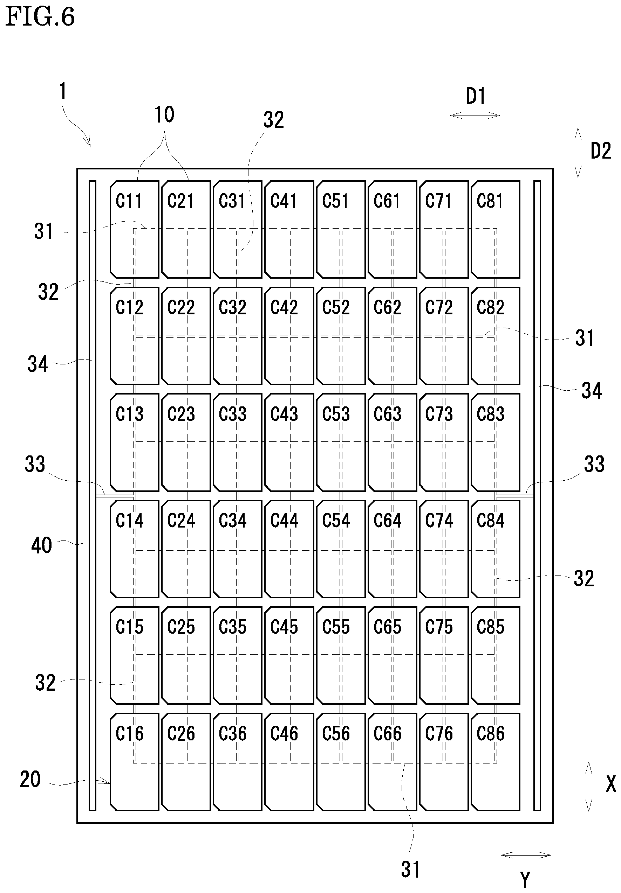

FIG. 6 is a schematic plan view of a structure of a solar cell module 1 in accordance with Embodiment 2 of the present disclosure.

In the present disclosure, the installation configuration and connection configuration of the plurality of solar cells 10 in the solar cell module 1 are not limited to those shown in Embodiment 1 above, and the solar cell module 1 may be implemented in various configurations. Throughout the following description of the solar cell module 1 in accordance with Embodiments 2 to 4, members of Embodiments 2 to 4 that are common with Embodiment 1 above are indicated by the same reference numerals, and description thereof is not repeated.

In the configuration shown in FIG. 6, the solar cell module 1 includes a total of 8×6 = 48 solar cells 10 (C11 to C16, C21 to C26, C31 to C36, C41 to C46, C51 to C56, C61 to C66, C71 to C76, C81 to C86) arranged in the first direction D1 and the second direction D2 to form a solar cell group 20. The solar cell module 1 includes a panel 40 the lengthwise direction of which is the second direction D2.

As an example, the solar cells C11, C21, which are disposed adjacent to each other in the first direction D1, are connected in series with each other by the first connection member 31 disposed in the first direction D1. Meanwhile, the solar cells C11, C12, which are disposed adjacent to each other in the second direction D2, are connected in parallel with each other by the second connection member 32 disposed in the second direction D2. The solar cells C15, C16, which are disposed adjacent to each other in the second direction D2, are similarly connected in parallel with each other by the second connection member 32. Each solar cell 10 is orientated so that one of the sides thereof that has two beveled corners is parallel to the second direction D2.

The plurality of solar cells 10 in the solar cell module 1 are configured so that one of every two solar cells 10 that are adjacent to each other in the first direction D1 is electrically connected in series with the other one of the two solar cells 10 and that one of every two solar cells 10 that are adjacent to each other in the second direction D2 is electrically connected in parallel with the other one of the two solar cells 10, to form the solar cell group 20. Along the edge of the solar cell group 20, an intermediate connection wire 33 is connected to the second connection member 32 between solar cells C13, C14 which are adjacent to each other in the second direction D2 and between solar cells C83, C84 which are adjacent to each other in the second direction D2 and is further connected to the edge electrode wire 34 via the intermediate connection wire 33.

In such a case, the solar power generation system is preferably configured such that the solar cell module 1 is installed in such a manner that the first direction D1 corresponds to the width direction Y of the vehicle 60 and the second direction D2 corresponds to the front-back direction X of the vehicle 60. This configuration enables making a full use of the area of the roof 63 of the vehicle 60 for the installation of the solar cell module 1, and similarly to the solar cell module 1 in accordance with Embodiment 1 above, the electric current value of one of the solar cells 10 can be prevented from being capped and reduced by the low electric current value of the other solar cell 10 through the parallel-connected circuitry of the solar cells 10, which enables restraining decreases in the electric power generation.

### Embodiment 3

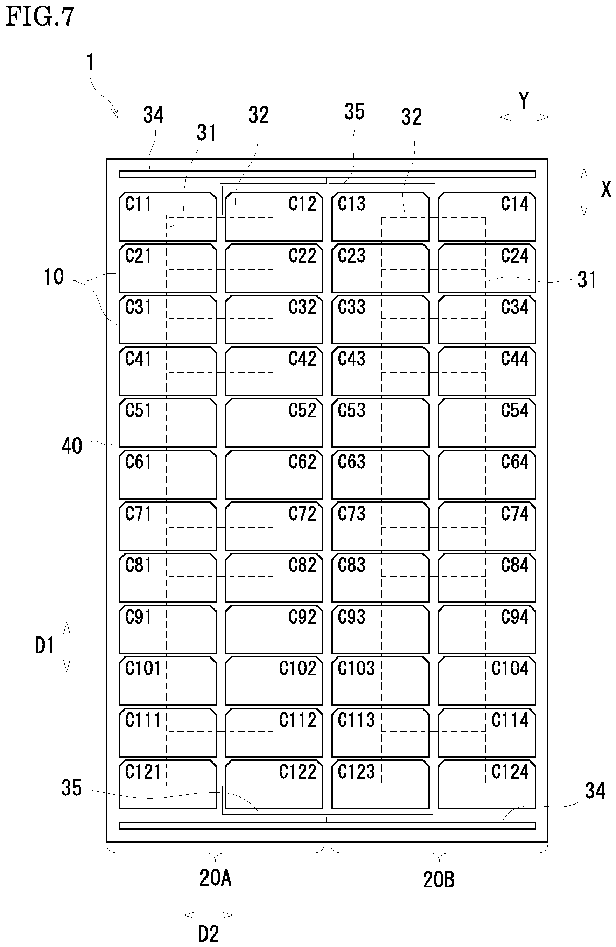

FIG. 7 is a schematic plan view of a structure of a solar cell module 1 in accordance with Embodiment 3 of the present disclosure.

In the present disclosure, the solar cell module 1 does not necessarily include only one solar cell group 20 and may include a plurality of solar cell groups 20. Referring to FIG. 7, the solar cell module 1 includes two solar cell groups 20A, 20B that are disposed adjacent to each other in the second direction D2.

The solar cell group 20Aincludes a total of 2×12 = 24 solar cells 10 (C11 to C12, C21 to C22, C31 to C32, C41 to C42, C51 to C52, C61 to C62, C71 to C72, C81 to C82, C91 to C92, C101 to C102, C111 to C112, C121 to C122) in the first direction D1 and the second direction D2.

In the solar cell group 20A, for example, the solar cells C 11, C21, which are adjacent to each other in the first direction D1, are connected in series with each other by the first connection member 31 disposed in the first direction D1. Meanwhile, the solar cells C11, C12, which are adjacent to each other in the second direction D2, are connected in parallel with each other by the second connection member 32 disposed in the second direction D2.

The solar cell group 20B includes a total of 2×12 = 24 solar cells 10 (C13 to C14, C23 to C24, C33 to C34, C43 to C44, C53 to C54, C63 to C64, C73 to C74, C83 to C84, C93 to C94, C103 to C104, C113 to C114, C123 to C124) in the first direction D1 and the second direction D2.

In the solar cell group 20B, for example, the solar cells C24, C34, which are adjacent to each other in the first direction D1, are connected in series with each other by the first connection member 31 disposed in the first direction D1. Meanwhile, the solar cells C13, C14, which are adjacent to each other in the second direction D2, are connected in parallel with each other by the second connection member 32 disposed in the second direction D2.

In both the solar cell groups 20A, 20B, the plurality of solar cells 10 in the solar cell module 1 are configured in this manner so that one of every two solar cells 10 that are adjacent to each other in the first direction D1 is electrically connected in series with the other one of the two solar cells 10 and that one of every two solar cells 10 that are adjacent to each other in the second direction D2 is electrically connected in parallel with the other one of the two solar cells 10. Each solar cell 10 is orientated so that one of the sides thereof that has two beveled corners is parallel to the second direction D2.

In addition, the solar cell group 20A, which is one of the two solar cell groups 20A, 20B, and the solar cell group 20B, which is the other one of the two solar cell groups 20A, 20B, include an equal number of solar cells 10 disposed in the first direction D1. In FIG. 7, there are provided 12 solar cells 10 in the first direction D1. In addition, the solar cell group 20A, which is one of the two adjacent solar cell groups 20A, 20B, includes the same total number of solar cells 10 as does the solar cell group 20B, which is the other one of the two adjacent solar cell groups 20A, 20B. Then, these adjacent solar cell groups 20A, 20B are electrically connected in parallel with each other via an intermediate connection wire 35.

Given the installation configuration of the solar cell module 1 in accordance with the present embodiment on the roof 63 of the vehicle 60, the solar power generation system is preferably configured as an installation configuration in which the lengthwise direction of the panel 40 matches the first direction D1, the first direction D1 corresponds to the front-back direction X of the vehicle 60, and the second direction D2 corresponds to the width direction Y of the vehicle 60. This configuration enables making a full use of the area of the roof 63 of the vehicle 60 for the installation of the solar cell module 1 and also enables restraining the electric power generation from decreasing due to a reduced electric current value.

### Embodiment 4

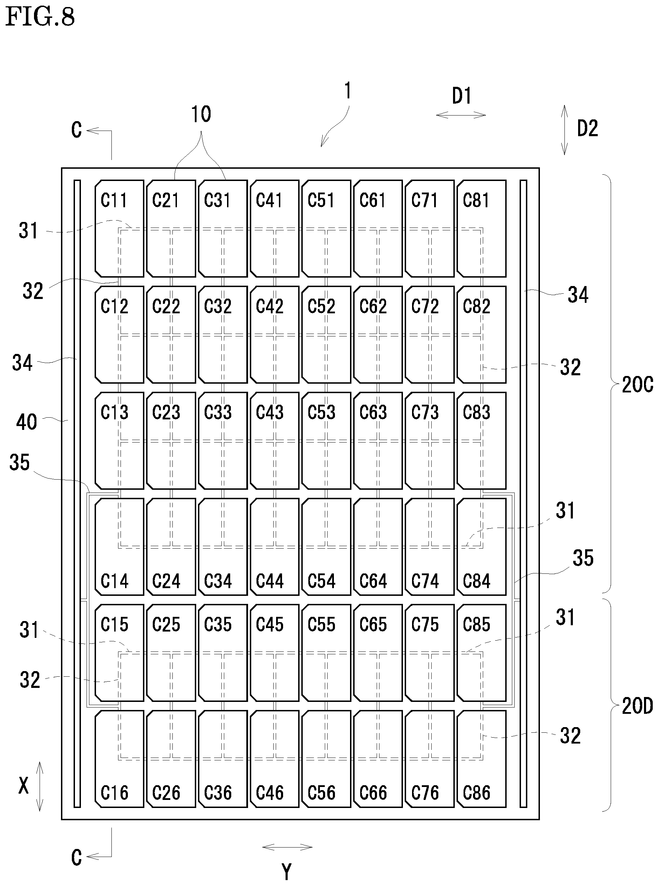

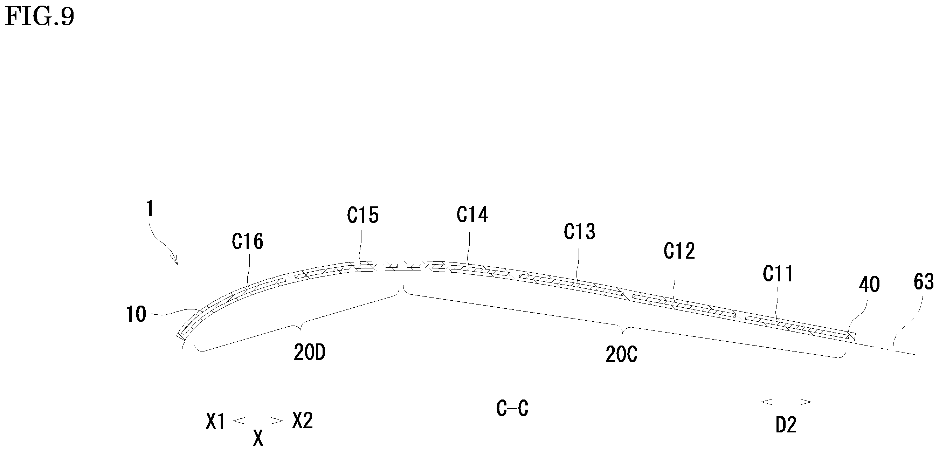

FIG. 8 is a schematic plan view of a structure of a solar cell module 1 in accordance with Embodiment 4 of the present disclosure. FIG. 9 is a schematic cross-section view, taken along line C-C in FIG. 8, of the solar cell module 1 when installed on the vehicle 60 as a solar power generation system.

When the solar cell module 1 includes a plurality of solar cell groups 20, the solar cell groups 20 may be arranged so as to match the curved-face shape of the installation surface, and each solar cell group 20 may include s different number of solar cells 10.

For instance, the solar cell module 1 in accordance with this configuration includes two solar cell groups 20C, 20D. The panel 40 in the solar cell module 1 has the lengthwise direction thereof parallel to the second direction D2 and the solar cell groups 20C, 20D are arranged adjacent to each other in the second direction D2. Each solar cell 10 is orientated so that one of the sides thereof that has two beveled corners is parallel to the second direction D2.

The solar cell group 20C in the solar cell module 1 includes a total of 8×4 = 32 solar cells 10 (C11 to C14, C21 to C24, C31 to C34, C41 to C44, C51 to C54, C61 to C64, C71 to C74, C81 to C84) in the first direction D1 and the second direction D2.

In the solar cell group 20C, for example, the solar cells C11, C21, which are adjacent to each other in the first direction D1, are connected in series with each other by the first connection member 31 disposed in the first direction D1. Meanwhile, the solar cells C11, C12, which are adjacent to each other in the second direction D2, are connected in parallel with each other by the second connection member 32 disposed in the second direction D2.

The solar cell group 20D includes a total of 8×2 = 16 solar cells 10 (C15 to C16, C25 to C26, C35 to C36, C45 to C46, C55 to C56, C65 to C66, C75 to C76, C85 to C86) in the first direction D1 and the second direction D2.

In the solar cell group 20D, for example, the solar cells C75, C85, which are adjacent to each other in the first direction D1, are connected in series with each other by the first connection member 31 disposed in the first direction D1. Meanwhile, the solar cells C85, C86, which are adjacent to each other in the second direction D2, are connected in parallel with each other by the second connection member 32 disposed in the second direction D2.

In this configuration, the solar cell module 1 is again configured so that one of every two solar cells 10 that are adjacent to each other in the first direction D1 is electrically connected in series with the other one of the two solar cells 10 and that one of every two solar cells 10 that are adjacent to each other in the second direction D2 is electrically connected in parallel with the other one of the two solar cells 10. Here, the solar cell group 20C, which is one of the two solar cell groups, includes 32 solar cells 10, whereas the solar cell group 20D, which is the other one of the two solar cell groups, includes 16 solar cells 10, the solar cell group 20C including more solar cells 10 than the solar cell group 20D. The solar cell group 20C includes the same number of solar cells 10 in the first direction D1 as does the solar cell group 20D. Then, these adjacent solar cell groups 20C, 20D are electrically connected in parallel with each other via an intermediate connection wire 35.

In the solar power generation system including the solar cell module 1 in accordance with the present embodiment, given the installation configuration in which the roof 63 of the vehicle 60 provides an installation surface, a preferred installation configuration is such that the lengthwise direction of the panel 40 matches the second direction D2, the second direction D2 corresponds to the front-back direction X of the vehicle 60, and the first direction D1 corresponds to the width direction Y of the vehicle 60.

As shown as an example in FIG. 9, the solar cell module 1 is disposed so that the second direction D2 corresponds to the front-back direction X of the vehicle 60. In addition, the solar cell module 1 is preferably installed so as to dispose the solar cell C16 (C26, C36, C46, C56, C66, C76, C86) on the front side X1 of the vehicle 60 and dispose the solar cell C1 1 (C21, C31, C41, C51, C61, C71, C81) on the rear side X2 of the vehicle 60.

As described earlier, the roof 63 of the vehicle 60 has a curved-face shape with a curvature that changes along the front-back direction X. For example, the roof 63 has an ascending slope toward the rear side X2 from the vehicle front 61 (front side X1) to an intermediate portion along the front-back direction X and has a descending slope toward the vehicle rear 62 (rear side X2) from the intermediate portion. The front side X1 of the roof 63, which forms an ascending slope, has a curved-face shape with a larger curvature than the rear side X2 of the roof 63, which forms a descending slope.

As a solar power generation system, preferably, an arrangement unit for the plurality of disposed solar cells 10 is specified in accordance with the curved-face shape of the surface of the roof 63 that provides the installation surface, and one solar cell group 20C, 20D is disposed in each arrangement unit. In other words, as an installation configuration of the solar cell module 1, one arrangement unit of solar cells 10 is specified on the front side X1, and one arrangement unit of solar cells 10 is specified on the rear side X2, in accordance with the front side X1 and the rear side X2, which have different curvatures, of the roof 63. Then, the solar cell groups 20D, 20C are preferably arranged for each arrangement unit.

Referring to FIG. 9, the solar cell module 1 is installed so that the solar cell group 20D is disposed on the surface of the roof 63 that forms an ascending slope from the front side X1 toward the rear side X2 and that the solar cell group 20C is disposed on the surface of the roof 63 that forms a descending slope toward the rear side X2.

Although the solar cell 10 (C16, C15) disposed on the front side X1 and the solar cell 10 (C14, C13, C12, C11) disposed on the rear side X2 may have different electrical properties due to different curvatures of the installation surface, the solar cells 10 (C16, C15) for the curved segment with a relatively large curvature are provided in the solar cell group 20D, and the solar cells 10 (C14, C13, C12, C11) for the curved segment with a relatively small curvature are provided in the solar cell group 20C. As described earlier, the solar cell group 20D and the solar cell group 20C are electrically connected in parallel with each other via the intermediate connection wire 35. Therefore, the electric current value produced by one of the two solar cell groups can be prevented from being capped by a lower electric current value of the electric current produced by the other one of the two solar cell groups. Besides, since each of the solar cell groups 20D, 20C has both a connecting structure in which the solar cells 10 are connected in series with each other and a connecting structure in which the solar cells 10 are connected in parallel with each other, the electric current value can be prevented from being capped by a low electric current value of one of the solar cells 10 and consequently decreasing in each of the solar cell groups 20D, 20C.

Therefore, it becomes possible to restrain decreases in the electric power generation caused by a decrease in the electric current value available from the entire solar cell module 1. In addition, the solar cell module 1 can be installed by making a full use of the area of the roof 63 of the vehicle 60, and the provision of an installation configuration in accordance with the curved-face shape of the installation surface enables improving power generation efficiency.

As described here, when the solar cell module 1 is installed on an installation surface that has a curved-face shape, by specifying an arrangement unit for the solar cells 10 in accordance with the curved-face shape (in accordance with segments with different curvatures), providing one solar cell group 20 in each arrangement unit, and forming a solar power generation system in which the plurality of solar cell groups 20 are connected in parallel with each other, the electric power generation is more stabilized, and the power generation efficiency is further increased.

In addition, although a maximum voltage is specified in a solar power generation system that can be mounted to the vehicle 60, since any of the solar cell modules 1 in accordance with the foregoing embodiments has both a connecting structure in which the solar cells 10 are connected in series with each other and a connecting structure in which the solar cells 10 are connected in parallel with each other, the output voltage of the solar cell module 1 can be specified in a prescribed range to stabilize the electric power generation.

### Other Embodiments

The solar cell module 1 in accordance with the present disclosure may be implemented in various configurations other than Embodiments 1 to 4. In addition, since the solar cell module 1 has a curved-face shape, a solar power generation system may be constructed in which the surfaces of various structures with a curved-face shape, other than the roof 63 of the vehicle 60 given as an example, can be used as an installation surface.

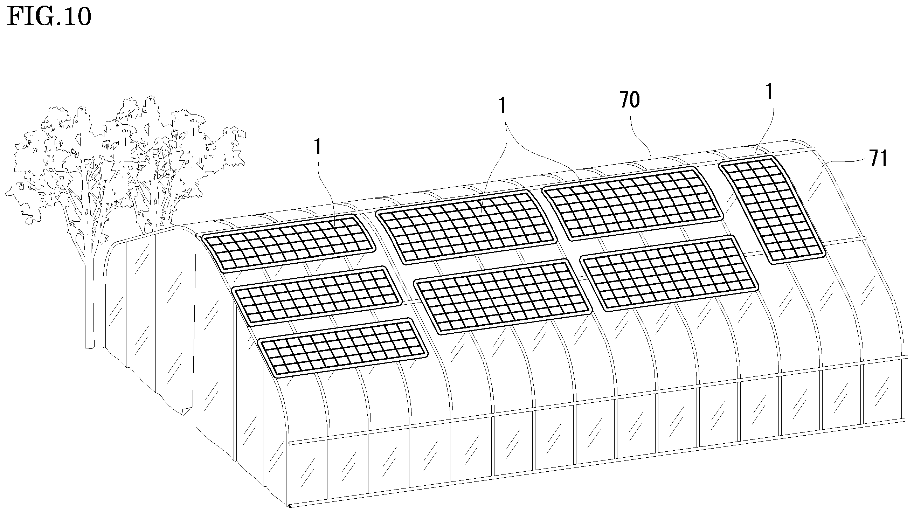

FIG. 10 is a perspective view of a plastic greenhouse 70 including a solar cell module 1 as another installation configuration for the solar power generation system in accordance with the present embodiment. For example, as shown in FIG. 10, the plastic greenhouse 70 is fixed on the ground and has a roof face 71 with a curved-face shape. The solar cell module 1 may be installed using the roof face 71 of the plastic greenhouse 70 with such a curved-face shape as an installation surface.

The solar cell module 1 installed on the roof face 71 can restrict the capping to a low electric current value even if there occurs a difference in the electric current value produced by the solar cells, thereby enabling stabilizing the electric power generation. In addition, the solar cell module 1 enables using the surfaces of structures with various curved-face shapes such as noise barriers for highways and the roof faces of car ports as an installation surface, thereby enabling stable electric power generation. The panel 40 in the solar cell module 1 may take various shapes, in addition to the shapes discussed as an example and may be partially flat, may partially have a different curvature, and may overall have a curved-face shape.

Note that the solar cell 10 in the solar cell module 1 may be either a single-sided light-receiving type or a double-sided light-receiving type. The type of solar cell 10 is not limited in any particular manner, and the solar cell 10 may be made of various semiconductor materials including polycrystalline semiconductors and thin film semiconductors.

Note that the present disclosure may be implemented in various forms without departing from its spirit and main features. Therefore, the aforementioned embodiments and examples are for illustrative purposes only in every respect and provide no basis for restrictive interpretations. The technical scope of the present disclosure is defined only by the claims and never bound by the embodiments and examples. Those modifications and variations that may lead to equivalents of claimed elements are all included within the scope of the disclosure.

The present application hereby claims priority to Japanese Patent Application No. 2021-121832 filed July 26, 2021, the entire contents of which are incorporated herein by reference.

### Reference Signs List

- 1: Solar cell module
- 10: Solar cell
- 101: Front-side electrode
- 102: Backside electrode
- 103: Busbar electrode
- 20: Solar cell group
- 20A, 20B, 20C, 20D: Solar cell group
- 31: First Connection member (connection member)
- 32: Second connection member (connection member)
- 33: Intermediate connection wire
- 34: Edge electrode wire
- 35: Intermediate connection wire
- 40: Panel
- 41: Transparent substrate
- 42: Protection member
- 43: Resin layer
- 60: Vehicle
- 63: Roof
- 70: Plastic greenhouse
- 71: Roof face
- D1: First direction
- D2: Second direction
- X: Front-back direction
- Y: Width direction

## Claims

1. A solar cell module comprising:
a plurality of solar cells spaced apart from each other and arranged in a first direction and a second direction perpendicular to the first direction; and
a connection member electrically connecting the plurality of solar cells, wherein
the plurality of solar cells are sealed by a resin layer having a curved-face shape and arranged along the curved-face shape, and
the solar cell module comprises a solar cell group in which the connection member electrically connects those solar cells in the plurality of solar cells that are adjacent to each other in the first direction in series with each other and electrically connects those solar cells in the plurality of solar cells that are adjacent to each other in the second direction in parallel with each other.

2. The solar cell module according to claim 1, wherein
the solar cell module comprises a plurality of the solar cell groups arranged in the second direction, and
those adjacent solar cell groups in the plurality of solar cell groups are electrically connected in parallel with each other.

3. The solar cell module according to claim 2, wherein those solar cells in the plurality of solar cells that are arranged in the first direction in one of adjacent solar cell groups in the plurality of solar cell groups are equal in number to those solar cells in the plurality of solar cells that are arranged in the first direction in another one of the adjacent solar cell groups.

4. The solar cell module according to claim 3, wherein those solar cells in the plurality of solar cells that are in one of adjacent solar cell groups in the plurality of solar cell groups are equal in total number to those solar cells in the plurality of solar cells that are in another one of the adjacent solar cell groups.

5. The solar cell module according to claim 3, wherein those solar cells in the plurality of solar cells that are in one of adjacent solar cell groups in the plurality of solar cell groups are greater in total number than those solar cells in the plurality of solar cells that are in another one of the adjacent solar cell groups.

6. A solar power generation system comprising the solar cell module according to any one of claims 1 to 5, the solar cell module being installed on an installation surface having a curved-face shape.

7. The solar power generation system according to claim 6, wherein
an arrangement unit is specified in which the plurality of solar cells are disposed in accordance with the curved-face shape of the installation surface, and one of the plurality of solar cell groups is provided in each arrangement unit, and
the plurality of solar cell groups in the solar cell module are electrically connected in parallel with each other.

8. The solar power generation system according to claim 6 or 7, wherein the installation surface is a surface of a vehicle.

9. The solar power generation system according to claim 6 or 7, wherein the installation surface is a surface of a structure fixed to ground.
